# EUROPEAN PATENT APPLICATION

(11) **EP 3 187 798 A1**
(43) Date of publication of application: **05.07.2017**
(21) Application number: 15837070.0
(22) Date of filing: 26.08.2015
(51) Int. Cl.: F25B 21/02, H01L 35/28

(54) **THERMAL DEVICE FOR SOLID AND LIQUID PRODUCTS**

(30) Priority: 29.08.2014 BR 102014021495
(71) Applicant: Berwanger Brochier, Felipe Osmar, CEP: 93525-240 Novo Hamburgo, RS (BR)
(72) Inventor: Berwanger Brochier, Felipe Osmar, CEP: 93525-240 Novo Hamburgo, RS (BR)
(74) Representative: Girardi, Giovanna Paola
(86) International application number: PCT/BR2015/000129
(87) International publication number: WO 2016/029284

(57) **Abstract**

*The present work depicts a thermal device for solid and liquid products consisting of a container with an external surface with one or more thermoelectric plates (20) or micro heat exchangers interconnected with a micro-compressor heat sink (30); this container (10) is placed on an eccentric axle (40) connected to a rotary electric motor or moving device (50) which increases the heat transfer coefficient by internal convection of the container (10) where the element to be cooled or heated is stored.*

## Description

### INVENTION FIELD

*The present invention describes a thermal device for solid and liquid products. More specifically, it consists of a device with heat dissipating elements, active elements for removing heat and* a *stirring device which increases the heat transfer coefficient through internal convection of the container where the element to be refrigerated or heated is placed.*

### INVENTION BACKGROUND

*Portable heaters or coolers are useful utensils in situations when changes in temperature are undesirable. Such devices usually feature micro-compressors or thermoelectric units which ensure constant temperatures, and, thus, enhance beverage and food preservation.*

*The state of art in technology describes devices for quick cooling of beverages, based on both compressor systems and Peltier systems.*

*Document* JP2006288987 *describes a device well suited for cooling a part of the body which presents a curved surface with Peltier plates.*

*Document* JP2005030726 *describes the installation cooling point for an environment by blowing cold air at the face of a user, having, for example, a Peltier element as a cooling source. A heat storage material is in contact with the Peltier element heating surface. When the Peltier element is activated, the heat storage material absorbs the heat generated on the heating surface of the Peltier element.*

*Document* FR2853400 *describes a beverage cooler consisting of a thermometer, heat-removing fans, a cooler which has walls sealed with a cooling accumulating gel and cooling generated by Peltier elements, a chamber for collecting bottles or cans and an instant temperature probe.*

*Document* JP2008249159 *describes a cooler fitted with an upper opening end and a lower end provided with a drain. A Peltier element is fixed on the cooler's peripheral surface; hence, once the Peltier element is energized, it quickly cools the beverage inside the cooler. A heat sink is installed on the Peltier element radiation surface, further enhancing its cooling effect.*

*Document* US6546737 *describes a cooler for beverages, such* as *beer, comprising of an inlet and outlet, and at least one heat exchanger between the inlet and outlet which the beverage can go through in order to cool by means of a set of Peltier plates connected to a power supply which generates two sides in the set, one cold and another hot.*

*Document* US4320626 *describes a portable container for cooling or heating liquids stored in it, comprised of a hollow body and a removable cap which features a cooling and heating thermoelectric Peltier type element that extends downwardly from the cap into the immersion liquid inside the container. A DC power supply allows the polarity of the direct current supplied to the thermoelectric to be reversed so that the immersion means can heat or cool the liquid placed inside the container.*

*As efficient* as *these state-of-the-art equipment can be in terms of cooling and heating, freezing* / *heating time can be reduced by adding a moving system to the container where the product to be refrigerated or heated is kept, in order to increase the efficiency of the heat exchange which, along with a portable refrigeration system, can guarantee the reduction of the refrigeration total time.*

*This way, the object of the current invention is a portable cooling device for solids and liquids which combines a refrigeration system using thermoelectric plates or micro-compressors and a rotating device in a portable unit, in order to provide quick heat exchange, considerably shortening the time required for refrigeration.*

### BRIEF DESCRIPTION OF THE PICTURES

*Picture 1 is the cross-sectional view of the container, showing the position of the thermoelectric plates and heat sinks.*
*Picture 2A shows the container placed on the rotating base in precession movement, Picture 2B shows the container in translational motion and Picture 2C shows the container in rotational movement.*

### FULL DESCRIPTION OF THE INVENTION

*For the purposes of the present invention, the following terms shall be understood:*
*Thermoelectric plates - units that use condensed matter technology to operate as heat pumps, based on the Peltier Effect and also in its opposite effect, the Seebeck. The Peltier effect is the production of a temperature gradient in two joints of two different-material conductors when subjected to an electric voltage in a closed circuit. In the Seebeck effect, opposite to the Peltier effect, the production of potential difference occurs due to the temperature difference in this same type of circuit.*

*The portable device for cooling solid and liquid products, object of the present invention, consists of a container with a hollow inner area (10) and an opening (11) for the insertion of the product or recipient which contains the product to be refrigerated; a cap is attached to its opening (11).*

*Preferably, both the external surface of the container (10) and the cap (12) shall be insulated with a thermal material (13) to prevent either heat gain or loss in the recipient (10).*

*One or more thermoelectric plates (20) are fixed directly on the external surface of the recipient (10) through a thermally conductive means without interference from the thermal insulation coating.*

*A thermal conductor (21) is fixed on the external surface of each thermoelectric plate (20) in order to transfer the heat from the thermoelectric plate (20) to the heat sink (30) placed over the thermal conductor (21), so as to extract heat from the inside of the container* (10).

*The container (10) is placed on an axle (40) connected to a rotating electrical motor (50) or to a moving device, allowing the precession, rotational and* / *or translational movement in order to increase the heat transfer coefficient by internal convection of the container (10), reducing the total refrigeration time of substance inside the container*

*The thermoelectric plates (20) can be replaced by compact heat exchangers interconnected with a micro-compressor, an expansion device and a reversing valve to form a steam compression freezing cycle, which can be reversed into a heat pump.*

*Optionally, an electronic module regulates the temperature of the fluid by means of sensors; this electronic module controls the adjustment of power supply in the thermoelectric plates (20), or in the* co*mpact heat exchangers interconnected with a micro-compressor, therefore reversing the voltage polarity of those thermoelectric plates (20) or of the compact heat exchangers interconnected with a micro-compressor using a switch, a relay or a transistor device so as to alternate the direction of the heat flow, promoting the increase or decrease of the temperature of the liquid or solid placed in the container.*

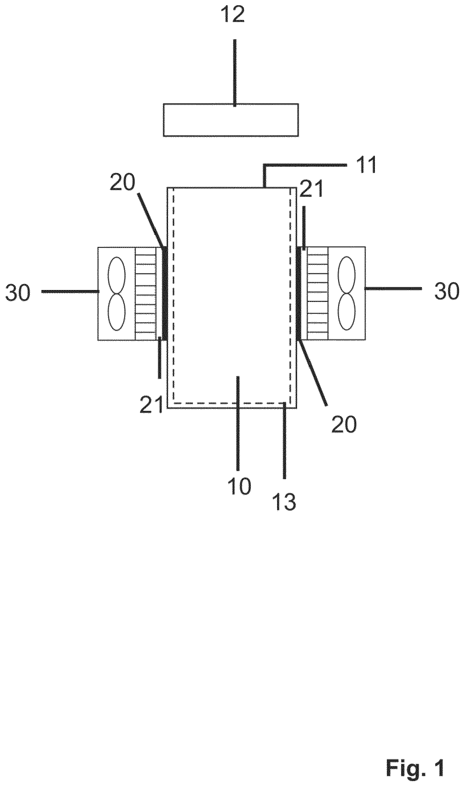

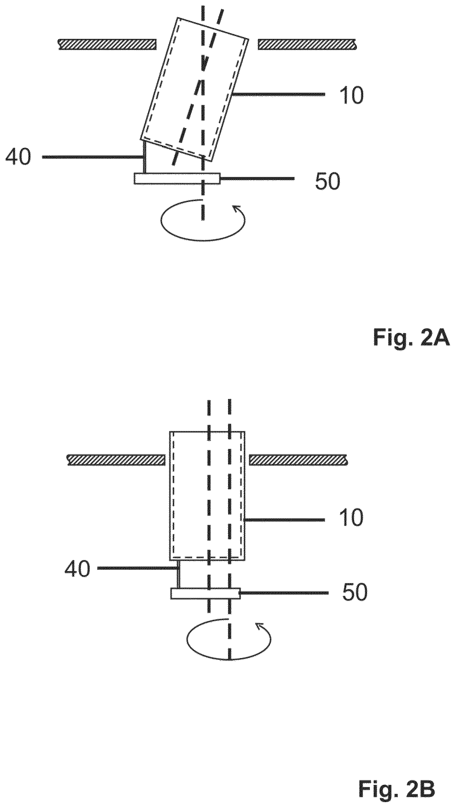

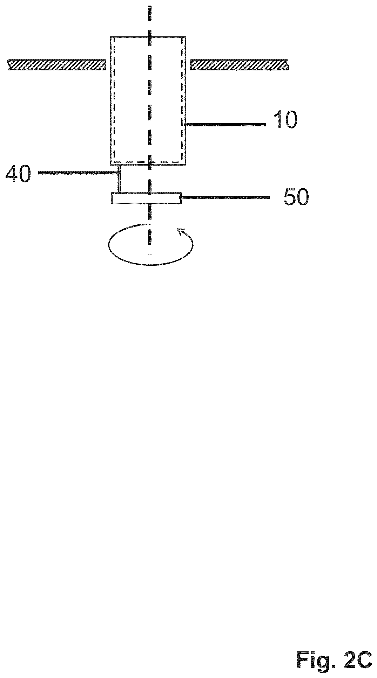

## Claims

1. *THERMAL DEVICE FOR SOLID AND LIQUID PRODUCTS which consists of a recipient with a hollow inner area (10) and an opening (11) through which the product or recipient containing the product to be refrigerated is inserted; ideally, a cap(12) is attached to that opening (11); preferably, the external surface of the container (10) and the cap (12) shall be insulated with a thermal material (13), **characterized by** the fact that one or more thermoelectric plates (20) are fixed directly to the external surface of the container (10) through a thermal conductive means with the outer surface of each thermoelectric plate (20) having a thermal conductor (21) for transferring the heat from the thermoelectric plate (20) to the heat sink (30); this container (10) is placed on an axle (40) connected to a rotary electric motor or moving device (50).*

2. *THERMAL DEVICE FOR SOLID AND LIQUID PRODUCTS, according to claim 1, **characterized by** the fact that the thermoelectric plates (20) are replaced by compact heat exchangers interconnected with a micro-compressor, an expansion device and a reversing valve.*

3. *THERMAL DEVICE FOR SOLID AND LIQUID PRODUCTS, according to claims 1 and 2, **characterized by** the fact that an optional electronic module may be included, which promotes the adjustment of the power supply to the thermoelectric plate (20) or to the compact heat exchangers interconnected with a micro-compressor, reversing the voltage polarity of that thermoelectric plate (20) or of the compact heat exchangers interconnected with a micro-compressor, using a key, a relay or a transistorized device.*
